# EUROPEAN PATENT APPLICATION

(11) **EP 2 511 711 A1**
(43) Date of publication of application: **17.10.2012**
(21) Application number: 12164195.5
(22) Date of filing: 13.04.2012
(51) Int. Cl.: G01R 15/18, G01R 19/20, H01H 85/30, H02H 3/04

(54) **Load monitoring in an electricity supply system**

(30) Priority: 14.04.2011 GB 201106334
(71) Applicant: Kelvatek Ltd., Knockmore Hill Industrial Park Lisburn, Co. Antrim BT28 2EX (GB)
(72) Inventor: Cunningham, John, Cookstown, County Tyrone BT80 8JG (GB); McIlroy, Colin, Dollingstown, County Down BT66 7TY (GB); Moore, Adrian, Lisburn, County Antrim BT28 2EX (GB)
(74) Representative: Wallace, Alan Hutchinson

(57) **Abstract**

A device (70) for monitoring one or more electrical characteristics of an electricity supply system. The monitoring device comprises a body (72) adapted to fit onto an electrical fuse contact (31,32) or around an electrical fuse and comprises a current measuring device and/or a voltage measuring device arranged to measure current and/or voltage at the fuse contact or through the electrical fuse during use.

## Description

### Field of the Invention

The present invention relates to monitoring electrical characteristics, for example electrical load in an electricity supply system.

### Background to the Invention

An electricity supply system typically comprises an electricity generator, a plurality of transformers and a plurality of consumer outlets, the aforesaid being interconnected by a network of electricity supply lines. The electricity supply network usually comprises a transmission network, for carrying electricity between the generator and a first set of transformers; a distribution network, for carrying electricity between the first set of transformers and a second set of transformers; and a mains network, for supplying electricity to the consumers. By way of example, the transmission network may carry high voltage (HV) signals of 66kV or above. The distribution network usually carries medium voltage (MV) signals of 11 kV or 22kV. The mains network usually carries low voltage (LV) signals which are, for example, 240V in the United Kingdom and 110V in the USA.

It is desirable to be able to monitor the electrical load in the electricity supply lines. In conventional systems, however, this cannot readily be done, not least because most of the supply lines are relatively inaccessible.

It would be desirable therefore to provide means for conveniently monitoring the load in electricity supply lines.

### Summary of the Invention

A first aspect of the invention provides a device for monitoring one or more electrical characteristics especially but not exclusively of an electricity supply system, the monitoring device comprising a body adapted to fit onto an electrical contact, especially a fuse contact, the device comprising a current measuring device and/or a voltage measuring device arranged to measure current and/or voltage at the electrical contact during use.

In preferred embodiments, said body is shaped and dimensioned to define an aperture for receiving said contact. The aperture is preferably a through-aperture and the body is typically dimensioned such that the electrical contact may project through the aperture and extend beyond the body for connection to a fuse, or other component.

Preferably, where said device comprises a current measuring device, said current measuring device comprises a current sensor arranged to sense by electromagnetic coupling current flowing through said fuse during use. Preferably, said current sensor comprises an annular current sensing device, for example a rogowski coil or a current transformer. Said body may be adapted to house or otherwise carry said annular current sensing device such that it encircles said aperture. The preferred arrangement is such that a portion of the body separates the current sensing device from the aperture. Hence, when the contact is inserted through the aperture, the current sensing device encircles the contact but is separated therefrom by said portion of the body. At least said portion of the body is formed from an electrically insulating material.

Alternatively, or in addition, said monitoring device may include voltage measuring means. Said voltage measuring means may comprise an electrical contact adapted to engage with said contact, or other component of said fuse or fuse holder, to which the device is to be fitted.

A second aspect of the invention provides a method of monitoring one or more electrical characteristics, e.g. electrical load, especially but not exclusively of an electricity supply system, the method comprising fitting a current measuring device and or a voltage measuring device around a fuse contact, said current measuring device comprising a current sensor arranged to sense by electromagnetic coupling current flowing through said fuse contact and/or said voltage measuring device comprising a contact for engagement with said fuse contact; and using an output signal generated by said current measuring device and being indicative of sensed current through said fuse contact, and/or using an output signal generated by said voltage measuring device and being indicative of measured voltage at said fuse contact, as an indication of, or to derive an indication of, electrical load, or at least one other electrical characteristic.

Another aspect of the invention provides a device for monitoring one or more electrical characteristics especially but not exclusively of an electricity supply system, the device comprising a fuse holder having a current measuring device adapted to fit around a fuse carried in use by said fuse holder, wherein said current measuring device comprises a current sensor arranged to sense by electromagnetic coupling current flowing through said fuse during use.

Said current measuring device may be arranged to fit around a portion of the fuse between the ends of the fuse. Alternatively, said current measuring device may be adapted to fit around an end of the fuse.

Preferably, said current sensor comprises an annular current sensing device, for example a rogowski coil or a current transformer. The fuse holder typically includes an annular portion adapted to house or otherwise include said current sensor, wherein the fuse, when carried by the fuse holder, passes through said annular portion.

In preferred embodiments, the fuse holder is adapted for connection to electrical fuse contacts such that, when said fuse is present, said fuse is electrically connected between said contacts. The electrical fuse contacts are typically incorporated into a supply line of said electrical supply system.

A further aspect of the invention provides a method of monitoring one or more electrical characteristics, e.g. electrical load, especially but not exclusively of an electricity supply system, the method comprising fitting a current measuring device around a fuse in a fuse holder, said current measuring device comprising a current sensor arranged to sense by electromagnetic coupling current flowing through said fuse; and using an output signal generated by said current measuring device and being indicative of sensed current through said fuse as an indication of, or to derive an indication of, electrical load, or at least one other electrical characteristic.

Another aspect of the invention provides an installation for monitoring one or more electrical characteristics, the installation comprising a monitoring device comprising a body removably fitted to an electrical contact or around an electrical fuse, the device comprising a current measuring device and/or a voltage measuring device arranged to measure current and/or voltage at the electrical contact or through the electrical fuse during use.

Preferred features are recited in the dependent claims.

Other advantageous aspects of the invention will become apparent to those ordinarily skilled in the art upon review of the following description of a specific embodiment and with reference to the accompanying drawings.

It will be understood that the word "supply" as used herein may embrace electricity supply, power supply and voltage supply, as appropriate.

### Brief Description of the Drawings

Specific embodiments of the invention are now described by way of example and with reference to the accompanying drawings in which like numerals are used to indicate like parts and in which:
Figure 1 is a schematic view of a conventional electricity supply network in the form of an open ring network by way of example only;
Figure 2 is a perspective view of a fuse device incorporating electrical load monitoring means and embodying an aspect of the invention, the device being shown mounted on electrical stalks;
Figure 3 is an alternative perspective view of the fuse device of Figure 2, not mounted on the stalks;
Figure 4 is a sectioned plan view of the device of Figure 2;
Figure 5 is a sectioned side view of the device of Figure 2;
Figure 6 is a perspective front view of an electrical load monitoring device embodying another aspect of the invention;
Figure 7 is a perspective rear view of the device of Figure 6;
Figure 8 is a perspective view of the device of Figure 6 mounted on an electrical stalk; and
Figure 9 is a sectioned side view of the device of Figure 6.

### Detailed Description of the Drawings

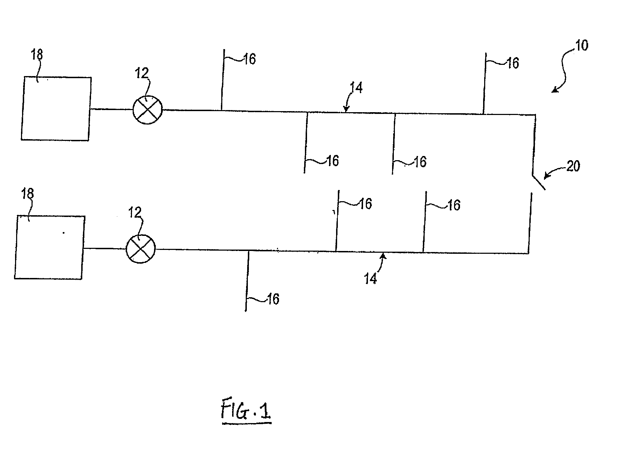

With reference to Figure 1 of the drawings, there is shown, generally indicated as 10, a conventional electricity supply network. The network 10 may form part of a larger electricity network, or system (not shown). In Figure 1, the network 10 takes the form of an open ring network by way of example only. The network 10 is of the type that may for example be used in a mains supply network and may include supply lines that are located underground.

The network 10 comprises a plurality of electrical supply lines including an open ring line 14 to which a plurality of feeder lines 16 are connected. The network 10 is connectable to an electricity supply which, in the present example, is provided by electrical substations or distribution units 18. Each end of open ring line 14 is connectable to a respective substation or distribution box 18 via a respective isolating device 12 which may, in a conventional network, take the form of a fuse or an automatic circuit recloser. The distribution units 18 may include one or more transformers (not shown) for transforming the electrical supply voltage to a level suitable for the network 10. The particular nature of the units 18 depends on which part of the supply system is being implemented by the network 10. The ring line 14 includes a normally open switch 20, which provides a normally open point (NOP) in the ring line 14. The electricity supply is usually a three phase supply but this is not described herein for reasons of clarity and since it is not instrumental in understanding the invention.

The network 10 may comprise, or form part of, a transmission network, a distribution network or a mains network and may be arranged to carry high voltage (HV), medium voltage (MV) or low voltage (LV) signals. In the present example, it is assumed that the network 10 is arranged for carrying MV (e.g. 11 kV or 22kV) or LV (e.g. 110V or 240V) signals. In the case where network 10 comprises an MV network, the network 10 typically comprises a distribution network and substations 18 are typically supplied by an electricity generator, for example a power station (not shown), via an HV transmission network (not shown). For an MV network, the feeders 16 normally supply electricity to further networks, or network portions, or to distribution substations, distribution transformers, or even large consumers, such as factories (not shown). In the case where network 10 comprises an LV network, the network 10 normally comprises a mains network and substations 18 are normally supplied by a distribution network (not shown). For an LV network, the feeders 16 normally supply electricity directly to domestic or commercial consumers.

At various locations in an electricity supply network sets of electrical contacts are provided for the connection of isolating devices such as fuses. In the example of network 10, the contacts may be provided for removable connection of the isolating device 12. More generally, the contacts may be located in a switchboard, distribution board, substation or other electrical apparatus included in the supply network. Typically, first and second contacts are provided, between which a fuse or other device can be removably connected.

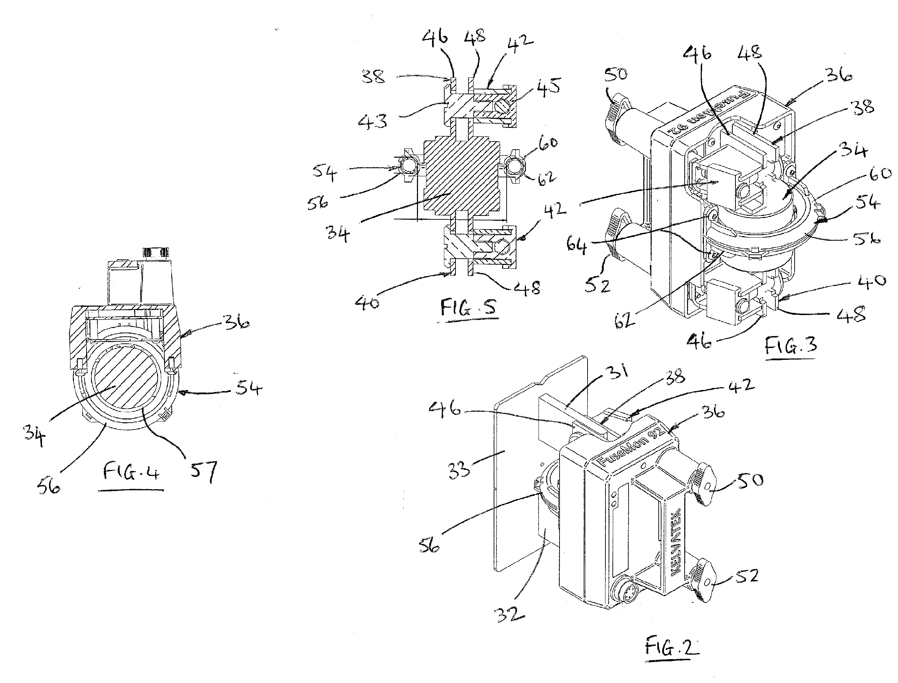

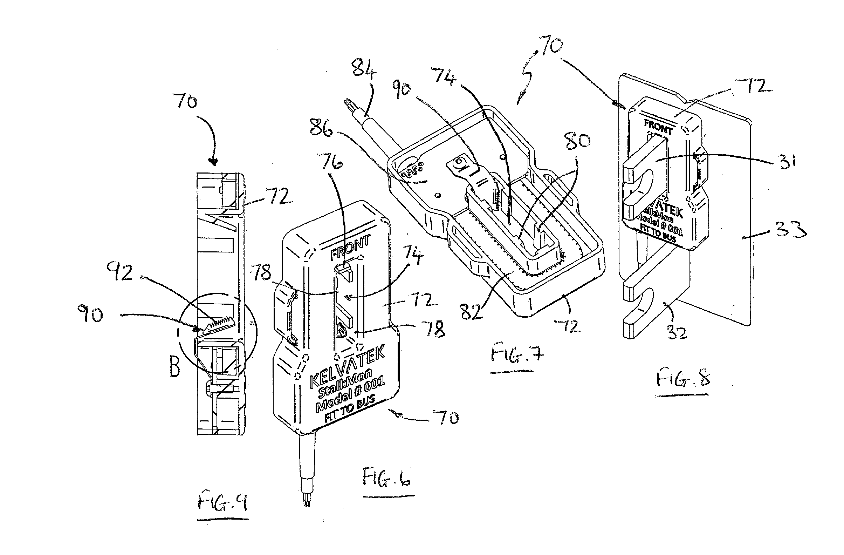

Figures 2 and 7 show first and second electrical contacts 31, 32 projecting from a plate 33. The contacts 31, 32 serve as respective electrical connectors to part of an electricity supply network (typically, the contacts 31, 32 are incorporated in to an electricity supply line) and as such are electrically conductive. In particular, the contacts 31, 32 are adapted to removably receive respective ends of an electrical fuse 34. When the fuse 34 is connected between the contacts 31, 32 an electrical connection is made between the contacts 31, 32 (assuming that the fuse 34 is not fused) to complete whatever electrical circuit of which the contacts 31, 32 are part. The contacts 31, 32 are commonly referred to as stalks or busbars.

Referring now in particular to Figures 2 to 5, the fuse 34 is carried by a fuse holder 36, typically removably so that a blown fuse 34 may be removed and replaced by an intact fuse 34. The fuse holder 36 may include any convenient means for releasably retaining the fuse 34 in the holder 36, e.g. one or more clips, pins, clamps, screws, sockets, supports and/or other retaining device. The fuse holder 36 is releasably connectable to the stalks 31, 32 such that respective ends 38, 40 of the fuse 34 are in contact with a respective one of the stalks 31, 32. The fuse holder 36 may be provided with any suitable releasable connecting means for this purpose. In the illustrated example, the fuse holder 36 includes a respective clamp 42 arranged to releasably clamp a respective end 38, 40 of the fuse 34 to the respective stalk 31, 32. In the illustrated example, the fuse 34 comprises a respective pair of spaced-apart plates 46, 48 at each end 38, 40 between which a respective stalk 31, 32 is received when the fuse holder 36 is mounted on the stalks 31, 32. The respective clamps 42 are operable, in this example by screws 50, 52, to clamp the respective stalks 31, 32 between the respective pairs of plates 46, 48, thereby maintaining an electrical connection between the fuse 34 and the stalks 31, 32, and so between the stalks themselves when the fuse is not ruptured. By way of example, each clamp 42 may comprise a respective pin 43 that is removably insertable into the body 45 of the clamp. With the pins 43 removed, the fuse 34 may be inserted into the fuse holder 36. The pins 43 may then be inserted into the body 45 of the respective clamp 42 thereby holding the fuse 34 in place.

The fuse device 36 includes a monitoring device, which may for example be used as an electrical load monitoring device, in the preferred form of an electrical current measuring device 54. The device 54 comprises a ring portion 56 shaped and dimensioned to allow it to fit around the fuse 34. In particular, the ring portion 56 is adapted to fit around the body 35 of the fuse between the fuse ends 38, 40, and more preferably around the portion of the body 35 that houses the fuse wire(s) (not visible). Typically, the fuse 34 has a longitudinal axis running in an end 38 to end 40 direction (the fuse wire(s) typically also running in the end-to-end direction), the ring portion 56 being positioned and orientated on the fuse holder 36 such that it lies in a plane that is substantially perpendicular with the longitudinal axis of the fuse 34, when the fuse 34 is fitted to the holder 36. To install the fuse 34, it may be passed through the aperture 57 defined by the ring portion 56. In the present example, the ends 38, 40 of the fuse 34 may then be connected to the clamps 42 as described above.

The ring portion 56 comprises a current sensing device (not visible), in particular an annular current sensing device that encircles the fuse 34 when fitted. The current sensing device does not make direct (physical or electrical) contact with the fuse 34, instead being configured to sense current flowing through the fuse by electromagnetic coupling. The current sensing device may for example comprise a rogowski coil or a current transformer. Preferably, the ring portion 56 comprises a housing 58 in which the current sensor is located. The housing 58 may be formed from an electrically insulating material, e.g. plastics or ceramic. Preferably, the ring portion 56 is dimensioned to provide a clearance space between the portion 56 and the fuse 34 when fitted. Conveniently, the housing 58 is openable, e.g. comprising one or more removable parts, to allow access to the current sensor and associated circuitry. In the illustrated embodiment, the housing 58 comprises upper and lower portions 60, 62 that are removable, e.g. by means of screws 64, for this purpose.

Typically, the current sensor requires electrical power and so the device 54 includes or is coupled to an electrical power source (not shown) for this purpose. For example, the device 54 may be connected to an external electrical power supply (e.g. a mains supply suitably transformed as necessary) by means of one or more power leads (not shown). Alternatively, the device 54 may include, or may be coupled to, an electrical power harvesting device (not shown), or one or more batteries.

The load monitoring device 54 also includes means for communicating with one or more remote devices (not shown) in order to transmit signals corresponding to measured current (and if necessary to receive signals from remote device(s)). To this end, one or more communication leads (not shown) may be connected to the device 54. Alternatively, the device 54 may include wireless communication means, e.g. a wireless transmitter or transceiver for communicating with remote device(s).

It will be apparent that the device 54 includes, or is otherwise operatively associated with, electrical circuitry (not shown) for facilitating the supply of power to the current sensor, for current/voltage measuring and for communicating with remote device(s), as is required. Such circuitry may be conventional and is not described further herein. It will be understood that some components of the device 54, or with which it co-operates, e.g. power source, or electrical circuitry, may be provided on the ring portion 56 but may alternatively, or in addition, be provided elsewhere, e.g. on the fuse holder 36.

In use, the current sensing device measures the current flowing through the fuse 34 and a corresponding signal is transmitted from the device 54 to any desired remote device(s). The measured current signal may be used as an indication of, or to derive an indication of, the electrical load in the part of the system into which the fuse 34 is incorporated.

In the preferred embodiment, the device 54 is located around the body of the fuse between the ends of the fuse, e.g. at or substantially at the middle of the fuse. In alternative embodiments, the device 54 may be adapted to fit around another part of the fuse or fuse device 36, e.g. a stalk or fuse end, which carries current in use.

Referring now in particular to Figures 6 to 9, there is shown an alternative electrical monitoring device 70. The device 70 is adapted to fit onto, preferably removably, an electrical contact. In particular, the device is adapted to fit onto a fuse contact 31, 32, or stalk, of an electrical supply system. The preferred device 70 comprises an annular body 72 that defines an aperture 74. The body 72 is shaped and dimensioned such that the stalk 31, 32, fits through the aperture 74. In typical embodiments, the aperture is a through-aperture since it is necessary for the stalk 31, 32, to project through the aperture 74 so that it can be connected to the fuse 34. For the same reason, the thickness (or other relevant dimension(s)) of the body 72 is selected such that the stalk 31, 32 projects through the aperture 74 and is exposed for connection to the fuse 34.

Advantageously, the body 72 is shaped and dimensioned to create a relatively close fit between the aperture 74 and stalk 31, 32. It is preferred that there is physical contact between the body 72 and the stalk 31, 32 at least at an upper portion 76 of the aperture 74 and opposing side portions 78, preferably still around all sides/surfaces of the stalk 31, 32. In the preferred embodiment, the body 72 is shaped and dimensioned to create a friction fit between the body 72 and stalk 31, 32. The body 72 is advantageously self-retaining on the stalk 31, 32, e.g. may means of said friction fit. A plurality of spaced apart bosses 80 may be provided around the aperture 74 to facilitate the fit between the body 72 and the stalk 31, 32. In the illustrated embodiment, the aperture 74 is substantially rectangular in shape and so substantially matches the shape of the stalk 31, 32. It will be understood that the aperture 74 may take other shapes, especially to suit differently shaped stalks. The body 72, or at least the portion of the body 72 that contacts the stalk 31, 32, is formed from an electrically insulating material, e.g. plastics or ceramic.

The preferred device 70 comprises a current sensing device, in particular an annular current sensing device 82 that encircles the stalk 31,32 when the device 70 is fitted. The current sensing device does not make direct contact with the stalk 31, 32, instead being configured to sense current flowing through the stalk 31, 32 by electromagnetic coupling. The current sensing device 82 may for example comprise a rogowski coil or a current transformer. The body 72 is shaped and dimensioned to house or otherwise carry the current sensor 82 such that it encircles the aperture 74. In particular, the current sensor 82 encircles the portion of the body 27 that defines the aperture 74 such that said portion is located between the sensor 82 and the aperture 74.

Typically, the current sensor 82 requires electrical power and so the device 70 includes or is coupled to an electrical power source (not shown) for this purpose. For example, the device 70 may be connected to an external power source by means of one or more power leads 84. Alternatively, the device 70 may include, or may be coupled to, an electrical power harvesting device (not shown).

The device 70 also includes means for communicating with one or more remote devices (not shown) in order to transmit signals corresponding to measured current (and if necessary to receive signals from remote device(s)). To this end, one or more communication leads 84 may be connected to the device 70. Alternatively, the device 70 may include wireless communication means, e.g. a wireless transmitter or transceiver for communicating with remote device(s).

It will be apparent that the device 70 includes, or is otherwise operatively associated with, electrical circuitry for facilitating the supply of power to the current sensor, for current/voltage measuring and for communicating with remote device(s), as is required. Such circuitry may be conventional and is not described further herein. It will be understood that some components of the device 70, or with which it co-operates, e.g. power source, or electrical circuitry, may be provided on the body 72 (e.g. the illustrated embodiment includes a circuit board 86 for this purpose) but may alternatively, or in addition, be provided elsewhere.

In use, the current sensing device 82 measures the current flowing through the stalk 31, 32 and a corresponding signal is transmitted from the device 70 to any desired remote device(s). The measured current signal may be used as an indication of, or to derive an indication of, the electrical load in the part of the system of which the stalk 31, 32 is part.

Optionally, the device 70 includes an electrical contact 90 for contacting the stalk 31, 32 when the device 70 is mounted thereon. The contact 90 makes electrical contact with the stalk 31, 32 and is also electrically connected to voltage measuring circuitry (not shown) provided on the device 70, e.g. on the circuit board 86 in the illustrated example. A stalk-engaging part 92 of the contact is located in the aperture 74 such that it engages with the stalk 31, 32, when the device 70 is fitted. Preferably, the part 92 is resiliently biased into engagement with the stalk 31, 32. For example, the part 92 may be arranged to be deflected by the stalk 31, 32 against a resilient bias, the bias conveniently being provided by the inherent physical characteristics of the part 92 itself, and/or some other biasing device. Conveniently, the contact 90, or at least part 92, comprises a strip of resiliently flexible, electrically conductive material, e.g. metal. Advantageously, the contact 90, and particularly the part 92 of the contact, is provided with teeth for engaging with the stalk 31, 32. The teeth help to make good contact with the stalk (e.g. cutting through any residual oxidation on the stalk) and improves the mechanical holding force.

In use, the device 70 measures the voltage at the stalk 31, 32 by means of the contact 90 and associated voltage measuring circuitry (not shown) included in or connected to the device 70. The voltage measuring circuitry may include or be electrically connectable to a voltage reference point, e.g. a neutral or earth connection, or a connection to any other convenient point, for example a component of the fuse device 36, such as the other stalk, or the fuse itself. The device 70 generates a corresponding signal, which is transmitted from the device 70 to any desired remote device(s). The measured current signal may be used as an indication of, or to derive an indication of, the electrical load in the part of the system of which the stalk 31, 32 is part.

In alternative embodiments, the device 70 may comprise the voltage measuring means (e.g. the contact 90 and associated voltage measuring circuitry) but not the current sensor 82. In such embodiments, the body 72 need not necessarily be annular and may be adapted to be mounted on or otherwise fitted to the stalk 31, 32 by any alternative suitable means.

In alternative embodiments, the contact 90 may be arranged to contact any other suitable voltage measurement point other than a stalk, for example an end of the fuse or any other component of the fuse device 36 that is electrically connected to the stalk.

As described herein, output signals generated by the devices 54, 70 may be used for the purpose of electrical load monitoring, especially in an electrical supply system. It will be understood that devices embodying the invention may be used for other purposes as is convenient, including any analysis of the electrical supply system, or other system into which the device is incorporated, that requires current and/or voltage measurements.

The invention is not limited to the embodiments described herein, which may be modified or varied without departing from the scope of the invention.

## Claims

1. A device for monitoring one or more electrical characteristics the monitoring device comprising a body adapted to fit onto an electrical contact or around an electrical fuse, the device comprising a current measuring device and/or a voltage measuring device arranged to measure current and/or voltage at the electrical contact or through the electrical fuse during use.

2. A device as claimed in claim 1, wherein said body is adapted to fit onto an electrical fuse contact.

3. A device as claimed in claim 1 or 2, wherein said body is shaped and dimensioned to define an aperture for receiving said contact.

4. A device as claimed in claim 3, wherein the aperture is a through-aperture.

5. A device as claimed in claim 4, wherein the body is dimensioned such that the aperture has a depth less than the length of the electrical contact.

6. A device as claimed in any preceding claim, wherein said device comprises a current measuring device, said current measuring device comprising a current sensor arranged to sense by electromagnetic coupling current flowing through said contact during use.

7. A device as claimed in claim 6, wherein said current sensor comprises an annular current sensing device, for example a rogowski coil or a current transformer.

8. A device as claimed in claim 7 when dependent on any one of claims 3 to 6, wherein said body is adapted to house or carry said annular current sensing device such that it encircles said aperture.

9. A device as claimed in claim 8, wherein a portion of the body separates the current sensing device from the aperture, said portion of the body preferably being formed from an electrically insulating material.

10. A device as claimed in any preceding claim, wherein device comprises voltage measuring means, said voltage measuring means comprising an electrical contact adapted to engage with said contact.

11. A device as claimed in claim 1, wherein comprising a fuse holder having a current measuring device adapted to fit around a fuse carried in use by said fuse holder, wherein said current measuring device comprises a current sensor arranged to sense by electromagnetic coupling current flowing through said fuse during use.

12. A device as claimed in claim 11, wherein said current sensor comprises an annular current sensing device, for example a rogowski coil or a current transformer, the fuse holder comprising an annular portion adapted to house or otherwise include said current sensor, wherein the fuse, when carried by the fuse holder, passes through said annular portion.

13. A method of monitoring one or more electrical characteristics, the method comprising fitting a current measuring device and or a voltage measuring device around a fuse contact, said current measuring device comprising a current sensor arranged to sense by electromagnetic coupling current flowing through said fuse contact and/or said voltage measuring device comprising a contact for engagement with said fuse contact; and using an output signal generated by said current measuring device and being indicative of sensed current through said fuse contact, and/or using an output signal generated by said voltage measuring device and being indicative of measured voltage at said fuse contact, as an indication of, or to derive an indication of, electrical load, or at least one other electrical characteristic.

14. An installation for monitoring one or more electrical characteristics, the installation comprising a monitoring device comprising a body removably fitted to an electrical contact or around an electrical fuse, the device comprising a current measuring device and/or a voltage measuring device arranged to measure current and/or voltage at the electrical contact or through the electrical fuse during use.

15. A method of monitoring one or more electrical characteristics, e.g. electrical load, especially but not exclusively of an electricity supply system, the method comprising fitting a current measuring device around a fuse in a fuse holder, said current measuring device comprising a current sensor arranged to sense by electromagnetic coupling current flowing through said fuse; and using an output signal generated by said current measuring device and being indicative of sensed current through said fuse as an indication of, or to derive an indication of, electrical load, or at least one other electrical characteristic.
